(19) Europäisches Patentamt
European Patent Office
Office européen des brevets

(11) **EP 2 739 982 B1**

(12) **FASCICULE DE BREVET EUROPEEN**

(45) Date de publication et mention de la délivrance du brevet:
**16.11.2022 Bulletin 2022/46**

(21) Numéro de dépôt: **12745467.6**

(22) Date de dépôt: **02.08.2012**

(51) Classification Internationale des Brevets (IPC):
***G01R 21/133*** *(2006.01)*     ***G01R 22/06*** *(2006.01)*

(52) Classification Coopérative des Brevets (CPC):
**G01R 21/133; G01R 22/063**

(86) Numéro de dépôt international:
**PCT/EP2012/065160**

(87) Numéro de publication internationale:
**WO 2013/017663 (07.02.2013 Gazette 2013/06)**

(54) **SYSTÈME DE MESURE DE L'ÉNERGIE ÉLECTRIQUE, POSTE DE TRANSFORMATION COMPRENANT UN TEL SYSTÈME ET PROCÉDÉ DE MESURE DE L'ÉNERGIE ÉLECTRIQUE AVEC UN TEL SYSTÈME**

SYSTEM ZUM MESSEN EINER ELEKTRISCHEN LEISTUNG, TRANSFORMATIONSEINHEIT MIT SOLCH EINEM SYSTEM UND VERFAHREN ZUM MESSEN EINER ELEKTRISCHEN LEISTUNG MIT SOLCH EINEM SYSTEM

SYSTEM FOR MEASURING ELECTRICAL POWER, TRANSFORMATION UNIT COMPRISING SUCH A SYSTEM AND METHOD FOR MEASURING ELECTRICAL POWER USING SUCH A SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.08.2011 FR 1157170**

(43) Date de publication de la demande:
**11.06.2014 Bulletin 2014/24**

(73) Titulaire: **Schneider Electric Industries SAS**
**92500 Rueil-Malmaison (FR)**

(72) Inventeurs:
• **COUTELOU, Olivier**
**F-38000 Grenoble (FR)**

• **HOUBRE, Pascal**
**F-38560 Jarrie (FR)**
• **VINCENT, François**
**F-38570 Le Cheylas (FR)**

(74) Mandataire: **Lavoix**
**62, rue de Bonnel**
**69448 Lyon Cedex 03 (FR)**

(56) Documents cités:
**WO-A1-2009/140777**     **GB-A- 2 452 989**
**US-A1- 2005 083 206**     **US-A1- 2005 222 784**
**US-A1- 2011 010 118**

**Description**

La présente invention concerne un système de mesure de l'énergie électrique du courant circulant dans au moins un conducteur électrique secondaire, le conducteur secondaire étant relié électriquement à un conducteur électrique primaire, le conducteur primaire et le ou chaque conducteur secondaire présentant sensiblement la même tension, ce système de mesure comprenant :

- un module primaire comportant un émetteur radioélectrique et un organe de mesure de la tension du conducteur primaire,
- au moins un module secondaire comportant un récepteur radioélectrique, un capteur de l'intensité du courant circulant dans le conducteur secondaire correspondant et un organe de calcul de l'énergie électrique dudit courant circulant dans le conducteur secondaire correspondant.

La présente invention concerne également un poste de transformation d'un courant électrique présentant une première tension alternative en un courant électrique présentant une deuxième tension alternative, ce poste de transformation comprenant un tel système de mesure.

La présente invention concerne également un procédé de mesure de l'énergie électrique avec un tel système de mesure.

On connaît des documents US 2005/0083206 A1 et WO 2009/140777 A1 un système de mesure du type précité.

On connaît également du document WO 2010/119332 A1 un système de mesure du type précité. Le système de mesure comprend des modules de mesure d'une énergie électrique, une base de données de stockage des valeurs mesurées de l'énergie et un module de gestion propre à fournir, à des clients distants, des informations correspondant aux valeurs mesurées et collectées. Les modules de mesure sont reliés par l'intermédiaire de liaisons radioélectriques à une passerelle de communication elle-même connectée à un réseau. La base de données, le module de gestion et les clients distants sont également reliés au réseau. Chaque module de mesure est propre à mesurer l'énergie électrique du courant circulant dans un conducteur électrique. Il comporte un capteur d'intensité, une unité de traitement propre à calculer l'énergie électrique et un émetteur-récepteur radioélectrique. Chaque module de mesure est synchronisé avec la passerelle de communication par l'intermédiaire d'une horloge.

Toutefois, un tel système de mesure est peu précis, le calcul du facteur de puissance s'effectuant par la détection des maximums de courant et de tension et le calcul du temps qui les sépare. Ce système est aussi peu précis car il ne prend pas en compte dans le calcul l'énergie produite par d'éventuelles harmoniques présentes dans les signaux de tension et de courant. De plus, un tel système de mesure est relativement complexe et coûteux.

Le but de l'invention est donc de proposer un système de mesure plus précis, moins complexe et moins coûteux.

A cet effet, l'invention a pour objet un système de mesure selon la revendication 1.

Suivant d'autres aspects avantageux de l'invention, le système de mesure comprend une ou plusieurs des caractéristiques des revendications 2 à 9 prise(s) isolément ou suivant toutes les combinaisons techniquement possibles.

L'invention a également pour objet un poste de transformation d'un courant électrique selon la revendication 10.

L'invention a également pour objet un procédé de mesure de l'énergie électrique selon la revendication 11.

Suivant un autre aspect avantageux de l'invention, le procédé de mesure comprend la caractéristique de la revendication 12.

L'homme du métier comprendra en outre que l'expression « *propre à* » définit à chaque fois une caractéristique du type « *moyen plus fonction* », et doit alors s'interpréter de manière identique à l'expression « *configuré pour* ».

Ces caractéristiques et avantages de l'invention apparaîtront à la lecture de la description qui va suivre, donnée uniquement à titre d'exemple, et faite en référence aux dessins annexés, sur lesquels :

- la figure 1 est une représentation schématique d'un poste de transformation comprenant un premier tableau, un deuxième tableau connecté au premier tableau par l'intermédiaire d'un transformateur et un système de mesure de l'énergie électrique du courant circulant dans des conducteurs de départ du deuxième tableau,
- la figure 2 est une représentation schématique du système de mesure de la figure 1, le système de mesure comprenant un module primaire de mesure de la tension, une pluralité de modules secondaires de mesure de l'intensité et un module de centralisation,
- la figure 3 est une représentation schématique du module secondaire de la figure 2,
- la figure 4 est un organigramme des étapes d'un procédé de mesure selon l'invention, mises en œuvre par le module primaire de la figure 2,
- la figure 5 est un organigramme des étapes du même procédé de mesure, mises en œuvre par les modules secondaires des figures 2 et 3,
- la figure 6 est un organigramme des étapes du même procédé de mesure, mises en œuvre par le module de centralisation de la figure 2, et

- la figure 7 est un chronogramme représentant les instants d'émission et de réception d'un premier message, celui-ci étant émis par le module primaire à destination des modules secondaires.

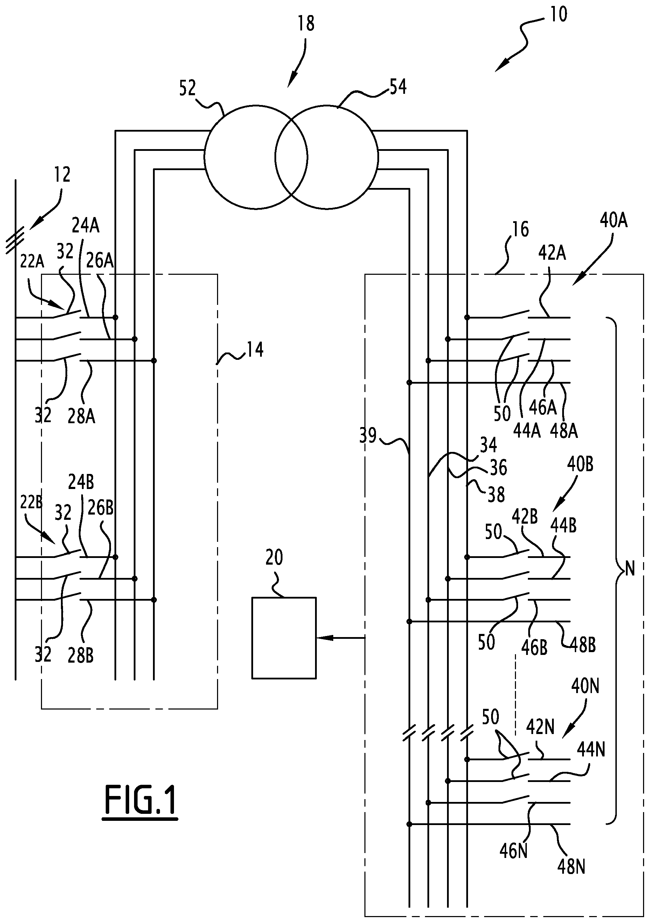

Sur la figure 1, un poste de transformation 10 connecté à un réseau électrique 12 comprend un premier tableau 14, un deuxième tableau 16, un transformateur électrique 18 connecté entre le premier tableau et le deuxième tableau et un système 20 de mesure de l'énergie électrique d'un courant.

Le poste de transformation 10 est propre à transformer le courant électrique délivré par le réseau 12 et présentant une première tension alternative, en un courant électrique présentant une deuxième tension alternative.

Le réseau électrique 12 est un réseau alternatif, tel qu'un réseau triphasé. Le réseau électrique 12 est un réseau moyenne tension, c'est-à-dire un réseau dont la tension est supérieure à 1 000 Volts et inférieure à 50 000 Volts. La première tension triphasée est alors une moyenne tension.

En variante, le réseau électrique 12 est un réseau haute tension, c'est-à-dire un réseau dont la tension est supérieure à 50 000 Volts. Autrement dit, la première tension triphasée est une haute tension.

Le premier tableau 14 comporte plusieurs arrivées 22, chaque arrivée 22 comportant un premier 24A, 24B, un deuxième 26A, 26B, et un troisième 28A, 28B conducteurs d'arrivée. Chaque premier, deuxième, troisième conducteur d'arrivée 24A, 24B, 26A, 26B, 28A, 28B est relié au réseau électrique par l'intermédiaire d'un disjoncteur d'arrivée 32 respectif. Le courant triphasé circulant dans les conducteurs d'arrivée 24A, 24B, 26A, 26B, 28A, 28B correspondants présente la première tension triphasée.

Le deuxième tableau 16 comprend un premier 34, un deuxième 36, un troisième 38 et un quatrième 39 conducteurs primaires et une pluralité N de départs 40A, 40B, ...40N, à savoir un premier départ 40A, un deuxième départ 40B, ..., un Nième départ 40N, chaque départ 40A, 40B, ..., 40N étant propre à délivrer une tension triphasée.

Chaque départ 40A, 40B, 40N est un départ basse tension, c'est-à-dire un départ dont la tension est inférieure à 1000 Volts. La deuxième tension triphasée est alors une basse tension.

En variante, chaque départ 40A, 40B, ..., 40N est un départ moyenne tension, c'est-à-dire un départ dont la tension est supérieure à 1000 Volts et inférieure à 50 000 Volts. Autrement dit, la deuxième tension triphasée est une moyenne tension.

Le premier départ 40A comporte un premier 42A, un deuxième 44A, un troisième 46A et un quatrième 48A conducteurs secondaires et trois disjoncteurs de départ 50. Les premier, deuxième et troisième conducteurs secondaires 42A, 42B, 42C sont respectivement reliés aux premier, deuxième et troisième conducteurs primaires 34, 36, 38 par l'intermédiaire d'un disjoncteur de départ 50 correspondant. Le quatrième conducteur secondaire 48A est directement connecté au quatrième conducteur primaire 39.

Les conducteurs primaires de départ 34, 36, 38 et les conducteurs secondaires de départ 42A, 44A, 46A correspondants présentent sensiblement la même tension, à savoir respectivement une première tension V1, une deuxième tension V2 et une troisième tension V3 correspondant aux trois phases de la deuxième tension triphasée.

Les autres départs 40B, ...40N sont identiques au premier départ 40A décrit précédemment, et comportent les mêmes éléments en remplaçant à chaque fois la lettre A par la lettre B, ..., N correspondante concernant les références des éléments.

Le transformateur électrique 18 est propre à transformer le courant issu du réseau électrique présentant la première tension alternative en le courant délivré au deuxième tableau 16 et présentant la deuxième tension alternative. Le transformateur électrique 18 comporte un enroulement primaire 52 connecté au premier tableau 14 et un enroulement secondaire 54 connecté au deuxième tableau 16.

Le système de mesure 20 est propre à mesurer l'énergie électrique du courant circulant dans le ou chaque conducteur secondaire de départ 42A, 44A, 46A, 42B, 44B, 46B, ..., 42N, 44N, 46N.

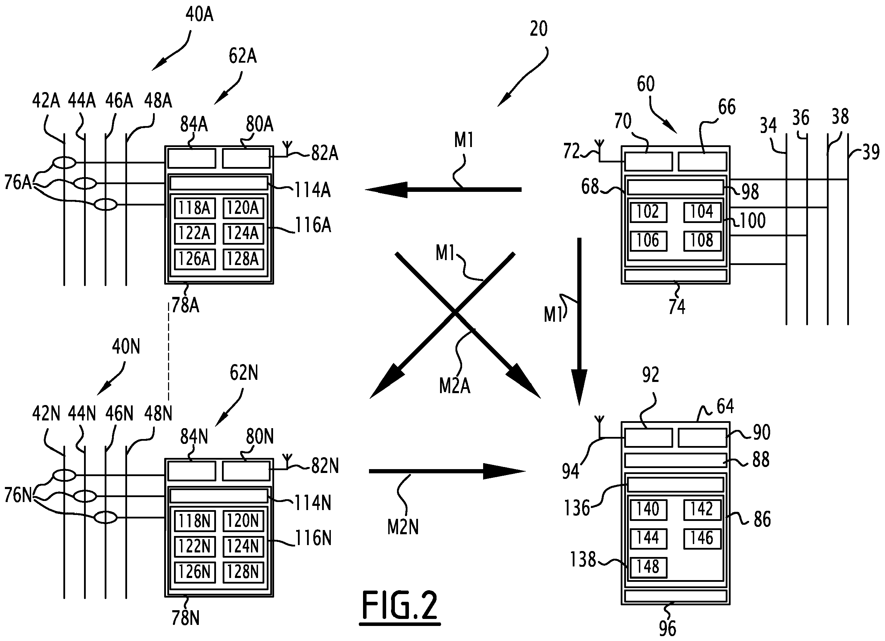

Le système de mesure 20, visible sur la figure 2, comprend un module primaire 60, une pluralité N de modules secondaires 62A, 62B, ..., 62N, à savoir un premier module secondaire 62A, un deuxième module secondaire 62B, non représenté, ... et un Nième module secondaire 62N, et un module de centralisation 64.

Le module primaire 60 comporte un organe 66 de mesure de la tension du courant circulant dans le conducteur primaire 34, 36, 38 correspondant, et une unité 68 de traitement d'information. Le module primaire 60 comporte également un émetteur-récepteur radioélectrique 70, une antenne radioélectrique 72, et un organe 74 d'alimentation électrique de l'organe de mesure, de l'unité de traitement d'information et de l'émetteur-récepteur radioélectrique.

Le premier module secondaire 62A comporte, pour chacun des premier 42A, deuxième 44A et troisième 46A conducteurs secondaires, un capteur 76A de l'intensité du courant circulant dans le conducteur secondaire 42A, 44A, 46A correspondant. Le premier module secondaire 62A comporte une unité 78A de traitement d'information, un émetteur-récepteur radioélectrique 80A, et une antenne radioélectrique 82A. Le premier module secondaire 62A comporte également un organe 84A d'alimentation électrique de l'unité de traitement d'information et de l'émetteur-récepteur radioélectrique. Le premier module secondaire 62A est identifié par un numéro unique, également appelé identifiant.

Les autres modules secondaires 62B, ..., 62N sont identiques au premier module secondaire 62A décrit précédemment, et comportent les mêmes éléments en remplaçant à chaque fois la lettre A par la lettre B, ..., N correspondante concernant les références des éléments. Chacun des autres modules secondaires 62B, ..., 62N présente également un identifiant unique.

Le module de centralisation 64 comporte une unité 86 de traitement d'information, une base de données 88 et une interface homme-machine 90. Le module de centralisation 64 comporte un émetteur-récepteur radioélectrique 92, une antenne radioélectrique 94 et un organe 96 d'alimentation électrique de l'unité de traitement d'information, de la base de données, de l'interface homme-machine et de l'émetteur-récepteur radioélectrique.

L'organe de mesure 66 est propre à mesurer la première tension V1 de la phase circulant à travers le premier conducteur primaire 34, également appelée phase numéro 1 et notée Phase_1, la deuxième tension V2 de la phase circulant à travers le deuxième conducteur primaire 36, également appelée phase numéro 2 et notée Phase_2, et la troisième tension V3 de la phase circulant à travers le troisième conducteur primaire 38, également appelée phase numéro 3 et notée Phase_3. L'organe de mesure 66 est également propre à mesurer la fréquence F de la tension triphasée circulant à travers les conducteurs primaires 34, 36, 38.

L'unité de traitement d'information 68 comporte un processeur 98 et une mémoire 100 apte à stocker un logiciel 102 de mesure des tensions V1, V2, V3 mesurées, un logiciel 104 de compression des échantillons des tensions mesurées. La mémoire 100 est apte à stocker un logiciel 106 d'émission d'un premier message M1 à destination de chaque module secondaire 62A, ..., 62N et du module de centralisation 64, et un logiciel 108 de distribution d'un unique jeton aux modules secondaires 62A, ..., 62N de manière successive.

L'émetteur-récepteur radioélectrique 70 est conforme au protocole de communication ZigBee basé sur la norme IEEE-802.15.4. En variante, l'émetteur-récepteur radioélectrique 70 est conforme à la norme IEEE-802.15.1 ou à la norme IEEE-802.15.2. En variante encore, l'émetteur-récepteur radioélectrique 70 est conforme à la norme IEEE-802-11.

L'antenne radioélectrique 72 est adaptée pour émettre des signaux radioélectriques à destination des antennes 82A, ..., 82N des modules secondaires et de l'antenne 94 du module de centralisation, et également pour recevoir des signaux radioélectriques desdites antennes 82A, ..., 82N, 94. Autrement dit, le module primaire 60 est relié à chacun des modules secondaires 62A, ..., 62N et au module de centralisation 64 par une liaison radioélectrique correspondante.

L'organe d'alimentation 74 est propre à alimenter électriquement l'organe de mesure 66, l'unité de traitement d'information 68 et l'émetteur-récepteur radioélectrique 70 à partir de la tension triphasée circulant à travers les conducteurs primaires 34, 36, 38.

Chaque capteur de l'intensité 76A du premier module secondaire 62A est propre à mesurer une intensité respective parmi une première intensité I1A circulant dans le premier conducteur secondaire de départ 42A, une deuxième intensité I2A circulant dans le deuxième conducteur secondaire de départ 44A et une troisième intensité I3A circulant dans le troisième conducteur secondaire de départ 46A.

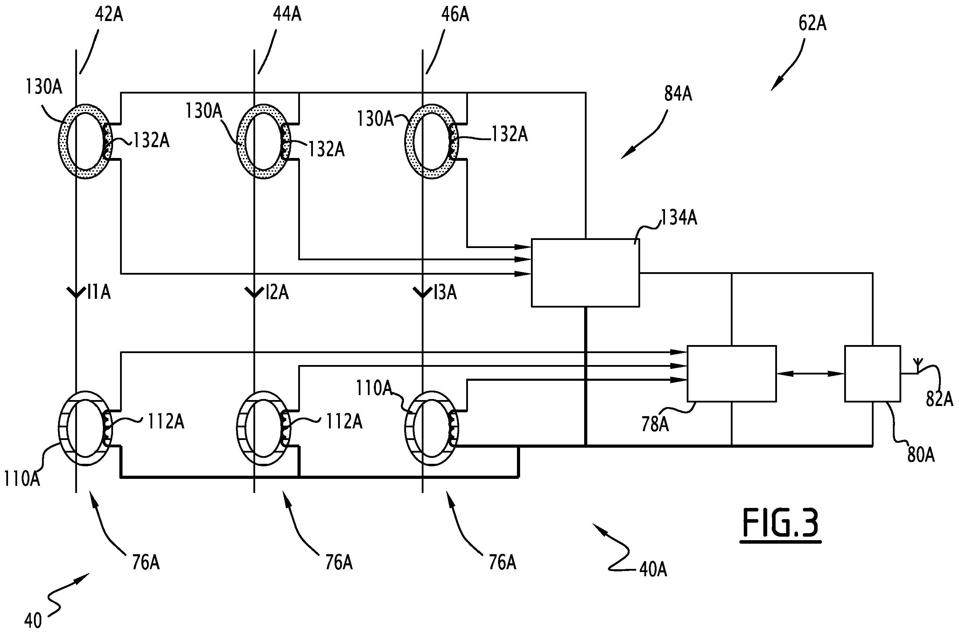

Chaque capteur de l'intensité 76A, également appelé capteur de courant, comporte un premier tore 110A disposé autour du conducteur secondaire de départ 42A, 44A, 46A correspondant et un premier enroulement 112A agencé autour du premier tore, comme représenté sur la figure 3. La circulation du courant à travers le conducteur secondaire de départ correspondant est propre à engendrer un courant induit proportionnel à l'intensité du courant dans le premier enroulement 112A. Le premier tore 110A est un tore de Rogowski. Le premier tore 110A est de préférence un tore ouvrant afin de faciliter son agencement autour des conducteurs correspondants.

L'unité de traitement d'information 78A, visible sur la figure 2, comporte un processeur de données 114A, et une mémoire 116A associée au processeur de données et propre à stocker un logiciel 118A de mesure des valeurs mesurées des intensités respectives, un logiciel 120A de réception du premier message M1, un logiciel 122A de synchronisation temporelle de chaque capteur de courant 76A par rapport à l'organe 66 de mesure de la tension. La mémoire 116A est apte à stocker un logiciel 124A de compression des valeurs échantillonnées des première, deuxième et troisième intensités I1A, I2A, I3A, un logiciel 126A de calcul de l'énergie électrique du courant circulant dans le conducteur secondaire 42A, 44A, 46A correspondant, et un logiciel 128A d'émission d'un deuxième message M2A à destination du module de centralisation 64.

L'émetteur-récepteur radioélectrique 80A est du même type que l'émetteur-récepteur radioélectrique 70.

L'antenne radioélectrique 82A, du même type que l'antenne radioélectrique 72, est adaptée pour recevoir des signaux radioélectriques de l'antenne 72 du module primaire et de l'antenne 94 du module de centralisation et également pour émettre des signaux radioélectriques aux antennes 72, 94.

L'organe d'alimentation 84A, visible sur la figure 3, est propre à alimenter l'unité de traitement d'information 78A et l'émetteur-récepteur radioélectrique 80A. L'organe d'alimentation 84A comporte, pour chacun des premier 42A, deuxième 44A et troisième 46A conducteurs secondaires, un deuxième tore 130A disposé autour du conducteur secondaire 42A, 44A, 46A correspondant et un deuxième enroulement 132A agencé autour du deuxième tore. La circulation du courant dans le conducteur secondaire 42A, 44A, 46A correspondant est propre à engendrer un courant induit dans le deuxième enroulement 132A.

L'organe d'alimentation 84A comporte un convertisseur 134A connecté à chacun des deuxièmes enroulements 132A et propre à délivrer une tension prédéterminée à l'unité de traitement d'information 78A et à l'émetteur-récepteur radioélectrique 80A. Chaque deuxième tore 130A est un tore en fer. Chaque deuxième tore 130A est de préférence un tore ouvrant afin de faciliter son agencement autour des conducteurs correspondants.

Autrement dit, le module secondaire 62A est autoalimenté par l'intermédiaire de l'organe d'alimentation 84A comportant les deuxièmes tores 130A adaptés pour récupérer l'énergie magnétique issue de la circulation du courant dans les conducteurs secondaires 42A, 44A, 46A correspondants.

Les éléments des autres modules secondaires 62B, ..., 62N sont identiques aux éléments du premier module secondaire 62A décrits précédemment, et comportent les mêmes sous-éléments en remplaçant à chaque fois la lettre A par la lettre B, ..., N correspondante concernant les références des sous-éléments.

L'unité de traitement d'information 86 du module de centralisation, visible sur la figure 2, comporte un processeur de données 136, et une mémoire 138 associée au processeur et apte à stocker un logiciel 140 de réception des premier et deuxièmes messages M1, M2A,..., M2N, un logiciel 142 d'enregistrement dans la base de données 88 des informations contenues dans les messages M1, M2A,..., M2N reçus. La mémoire 138 est propre à stocker un logiciel 144 de traitement desdites informations reçues, un logiciel 146 d'affichage de données et un logiciel 148 de transmission de données à destination d'un serveur distant, non représenté.

L'interface homme-machine 90 comporte un écran d'affichage et un clavier de saisie, non représentés. En variante, l'interface homme-machine 90 comporte un écran tactile et la saisie de données est réalisée par l'intermédiaire de touches tactiles affichées à l'écran.

L'émetteur-récepteur radioélectrique 92 est du même type que les émetteurs-récepteurs radioélectriques 70, 80A, ..., 80N.

L'antenne radioélectrique 94, du même type que les antennes radioélectriques 72, 82A, ..., 82N, est propre à recevoir des signaux radioélectriques issus de l'antenne 72 du module primaire et des antennes 82A, ..., 82N des modules secondaires et également à émettre des signaux radioélectriques à destination desdites antennes 72, 82A, ..., 82N.

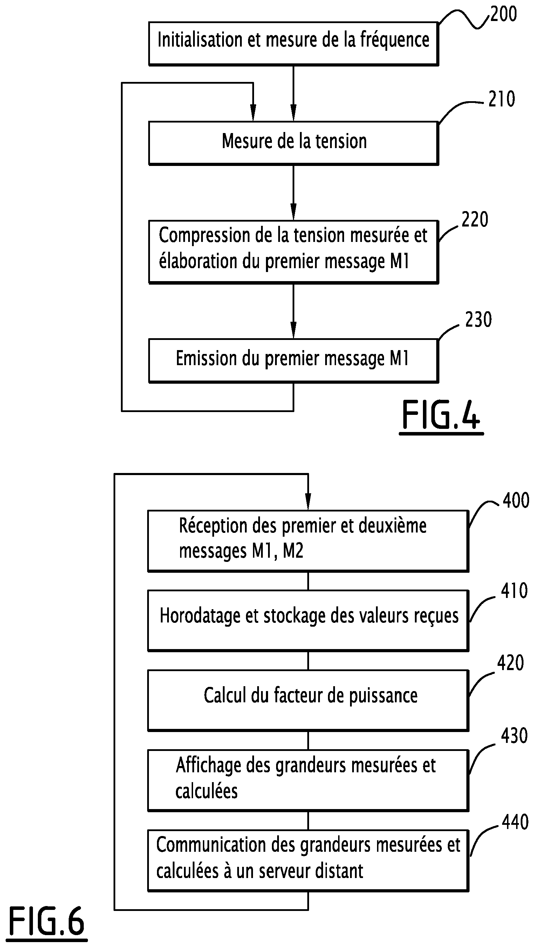

Le fonctionnement du système de mesure 20 va désormais être expliqué à l'aide des figures 4, 5 et 6 représentant des organigrammes des étapes d'un procédé de mesure mises en œuvre respectivement par le module primaire 60, par les modules secondaires 62A, ..., 62N et par le module de centralisation 64.

Comme représenté sur la figure 4, lors d'une première étape 200, le module primaire 60 s'initialise et mesure la fréquence F de la tension triphasée circulant à travers les conducteurs primaires 34, 36, 38 par l'intermédiaire du logiciel de mesure 102. La fréquence F de la tension triphasée est égale à 50 Hz.

Le module primaire 60 mesure ensuite, lors de l'étape 210, les première, deuxième et troisième tensions V1, V2, V3 à l'aide de son organe de mesure 66 et de son logiciel de mesure 102. Le logiciel 102 échantillonne en outre les valeurs mesurées des tensions V1, V2, V3. La période $P_{ech}$ d'échantillonnage de la tension mesurée est un multiple de la période $P_{tension}$ de la tension triphasée égale à l'inverse de la fréquence F de ladite tension triphasée mesurée précédemment lors de l'étape 200. La période $P_{tension}$ de la tension triphasée est égale à 20 ms.

Lors de l'étape 220, le module primaire 60 compresse les valeurs mesurées des tensions V1, V2, V3 à l'aide de son logiciel de compression 104, afin de limiter la quantité de données transmises par l'intermédiaire des liaisons radioélectriques entre le module primaire 60 et les modules secondaires 62A, ..., 62N,. Le logiciel de compression 104 est propre à calculer un nombre prédéterminé K des premiers coefficients Re_j(Vi), Im_j(Vi) de la décomposition en série de Fourier de chacune des tensions V1, V2, V3 des trois phases, où i est le numéro égal à 1, 2 ou 3 de la phase, et j est compris entre 1 et K. Le nombre prédéterminé K est de préférence égal à 5.

Les coefficients de la décomposition en série de Fourier sont, par exemple, obtenus par des opérations de corrélation sur les échantillons des valeurs mesurées. Plus précisément, le coefficient réel du fondamental, noté Re_1(Vi), est une corrélation, sur une durée égale à la période $P_{tension}$ de la tension triphasée, entre les échantillons du signal de tension Vi et un cosinus de fréquence égale à la fréquence F de la tension triphasée, où Vi représente la tension de la phase, i étant égal à 1, 2 ou 3. Le coefficient imaginaire du fondamental, noté Im_1 (Vi), est une corrélation, sur une durée égale à la période $P_{tension}$, entre les échantillons du signal de tension Vi et un sinus de fréquence égal à la fréquence F.

Le coefficient réel de l'harmonique numéro j, noté Re_j(Vi), j étant compris entre 2 et K, est la corrélation, sur une durée égale à la période $P_{tension}$, entre les échantillons du signal de tension Vi et un cosinus de fréquence égal à j fois la fréquence F. Le coefficient imaginaire de l'harmonique numéro j, noté Im_j(Vi), est la corrélation, sur une durée égale à la période $P_{tension}$, entre les échantillons du signal de tension Vi et un sinus de fréquence égal à j fois la fréquence F.

Le logiciel de compression 104 calcule ainsi les coefficients complexes Re_j(Vi), Im_j(Vi) des décompositions en série de Fourier des trois tensions V1, V2, V3 pour le fondamental et les harmoniques 2 à K.

Enfin, lors de l'étape 230, le module primaire 60 émet le premier message M1 à destination de chacun des modules secondaires 62A, ..., 62N et du module de centralisation 64. Le premier message M1 est de préférence émis périodiquement. La période d'émission $P_{émission}$ est prédéterminée, et de préférence égale à une seconde. Autrement dit, le premier message M1 est émis toutes les secondes.

Le premier message M1 contient notamment une donnée de synchronisation, la période d'échantillonnage $P_{ech}$, les coefficients Re_j(Vi), Im_j(Vi) des décompositions en série de Fourier des trois tensions V1, V2, V3 jusqu'à l'harmonique K, calculés précédemment lors de l'étape 220, et l'identifiant du module secondaire qui sera autorisé à émettre son deuxième message à destination du module de centralisation 64 après la réception du premier message M1. L'identifiant du module secondaire autorisé à émettre ses informations de mesure est déterminé à l'aide du logiciel de distribution du jeton unique 108, l'identifiant du module contenu dans le premier message M1 permettant de désigner le module secondaire à qui l'unique jeton a été attribué.

En complément, le premier message M1 contient les valeurs des moyennes quadratiques, également notées RMS (de l'anglais *Root Mean Square*), de chacune des trois tensions V1, V2, V3.

Après émission du premier message M1, le module primaire 60 retourne à l'étape 210 afin de mesurer à nouveau la tension V1, V2, V3 des phases de la tension triphasée circulant dans les conducteurs primaires 34, 36, 38.

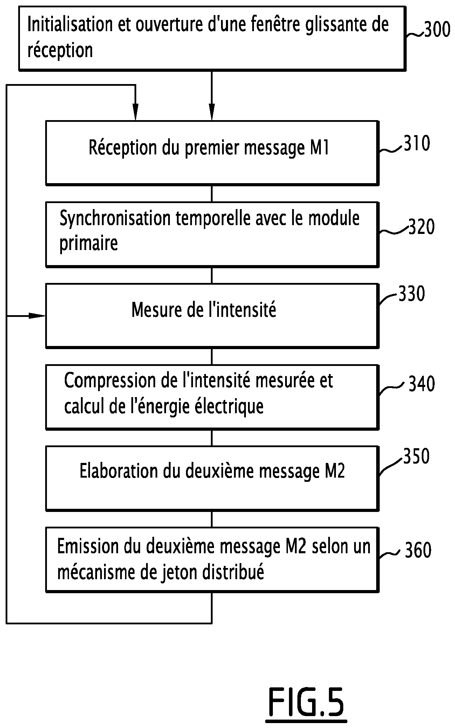

Les étapes, visibles sur la figure 5, du procédé de mesure mises en œuvre par les modules secondaires 62A, ..., 62N vont être à présent décrites pour le premier module secondaire 62A.

Lors de l'étape 300, le premier module secondaire 62A s'initialise et ouvre une fenêtre glissante de réception du premier message M1 à l'aide de son logiciel de réception 120A. La fenêtre de réception est une fenêtre présentant une durée de quelques dizaines de millisecondes que le premier module secondaire 62A fait glisser dans le temps.

Lors de la réception à l'aide du logiciel de réception 120A du premier message M1, le premier module secondaire 62A vérifie que le premier message M1 contient la donnée de synchronisation et passe alors à l'étape 320 de synchronisation temporelle avec le module primaire 60.

Lors de l'étape 320, le logiciel de synchronisation 122A initialise, à la date de réception du premier message M1, un compteur destiné à s'incrémenter jusqu'à une valeur correspondant à la période d'émission du premier message $P_{\text{émission}}$. Le module secondaire 62A retourne alors automatiquement à l'étape de réception 310 environ une milliseconde avant la réception attendue du prochain premier message M1. Le logiciel de synchronisation 122A effectue également la resynchronisation de l'échantillonnage à l'aide de la valeur de la période d'échantillonnage $P_{\text{ech}}$ contenue dans le premier message M1 et de la date de réception du premier message M1.

La date de réception du premier message M1 est la date de référence pour la synchronisation du premier module secondaire 62A par rapport au module primaire 60, et plus précisément pour la synchronisation de la mesure des intensités I1A, I2A, I3A par rapport à la mesure des tensions V1, V2, V3.

Si le premier message M1 n'est pas détecté par le premier module secondaire 62A, la fenêtre de réception est refermée et aucune synchronisation n'est effectuée.

Le premier module secondaire 62A mesure alors, lors de l'étape 330 et par l'intermédiaire de ses capteurs de courant 76A et de son logiciel de mesure 118A, chacune des première, deuxième et troisième intensités I1A, I2A, I3A. Le logiciel de mesure 118A échantillonne en outre les valeurs mesurées des trois intensités I1A, I2A, I3A, l'instant de début de l'échantillonnage ayant été réinitialisé lors de l'étape 320 précédente afin d'assurer la synchronisation temporelle du capteur de l'intensité 76A par rapport à l'organe de mesure de la tension 66.

Le logiciel de compression 124A compresse ensuite les valeurs mesurées des intensités I1A, I2A, I3A lors de l'étape 340. Le logiciel de compression 124A calcule, par exemple, le nombre prédéterminé K de premiers coefficients complexes Re_j(IiA), Im_j(IiA) de la décomposition en série de Fourier des trois courants I1A, I2A, I3A des trois phases de manière analogue au calcul, décrit pour l'étape 220, des coefficients complexes Re_j(Vi), Im_j(Vi) de la décomposition en série de Fourier des tensions.

Le coefficient réel du fondamental, également noté Re_1(IiA), est une corrélation, sur une durée égale à la période $P_{\text{tension}}$ de la tension triphasée, entre les échantillons du signal de l'intensité IiA et un cosinus de fréquence égal à la fréquence F de la tension triphasée, où IiA représente l'intensité de la phase numéro i, i étant égal à 1, 2 ou 3. Le coefficient imaginaire du fondamental, également noté Im_1(IiA), est une corrélation, sur une durée égale à la période $P_{\text{tension}}$, entre les échantillons du signal de l'intensité IiA et un sinus de fréquence égal à la fréquence F.

Le coefficient réel de l'harmonique numéro j, noté Re_j(IiA), j étant compris entre 2 et K, est la corrélation, sur une durée égale à la période $P_{\text{tension}}$, entre les échantillons du signal de l'intensité IiA et un cosinus de fréquence égal à j fois la fréquence F. Le coefficient imaginaire de l'harmonique numéro j, noté Im_j(IiA), j étant compris entre 2 et K, est la corrélation, sur une durée égale à la période $P_{\text{tension}}$, entre les échantillons du signal de l'intensité IiA et un sinus de fréquence égal à j fois la fréquence F.

Le logiciel de compression 124A calcule ainsi les coefficients complexes Re_j(IiA), Im_j(IiA) des décompositions en série de Fourier des trois intensités I1A, I2A, I3A pour le fondamental et les harmoniques 2 à K.

Le logiciel de calcul 126A calcule alors de manière périodique l'énergie active $E_1$, $E_2$, $E_3$ pour chacune des trois phases à partir des valeurs des tensions V1, V2, V3 mesurées reçues du module primaire 60 via le premier message M1 et des valeurs des intensités I1A, I2A, I3A mesurées par les capteurs de courant 76A. La période de calcul des énergies actives $E_1$, $E_2$, $E_3$ est égale à la période $P_{\text{tension}}$, soit par exemple 20 ms.

Les variations des tensions V1, V2, V3 sont suffisamment limitées entre deux instants d'émission du premier message M1, c'est-à-dire sur une période d'une seconde, pour permettre le calcul des énergies actives $E_1$, $E_2$, $E_3$ toutes les 20 ms, à partir des valeurs des intensités I1A, I2A, I3A mesurées toutes les 20 ms et des valeurs des tensions V1, V2, V3 reçues toutes les secondes.

Pour le calcul des énergies actives $E_1$, $E_2$, $E_3$, le logiciel de calcul 126A calcule, à chaque période $P_{tension}$, une puissance active $P_i$ de chaque phase numéro i, i étant égal à 1, 2 ou 3, à l'aide des équations suivantes :

$$P_{i,j} = \frac{[\mathrm{Re}\_j(Vi) \times \mathrm{Re}\_j(IiA) + \mathrm{Im}\_j(Vi) \times \mathrm{Im}\_j(IiA)]}{2} \qquad (1)$$

où j est compris entre 1 et K

$$P_i = \sum_{j=1}^{K} P_{i,j} \qquad (2)$$

Le logiciel de calcul 126A détermine également, à chaque période $P_{tension}$, la puissance réactive $Q_i$ de chaque phase numéro i, i étant égal à 1, 2 ou 3, à l'aide des équations suivantes :

$$Q_{i,j} = \frac{[\mathrm{Im}\_j(Vi) \times \mathrm{Re}\_j(IiA) - \mathrm{Re}\_j(Vi) \times \mathrm{Im}\_j(IiA)]}{2} \qquad (3)$$

où j est compris entre 1 et K

$$Q_i = \sum_{j=1}^{K} Q_{i,j} \qquad (4)$$

L'énergie active $E_i$ de chaque phase numéro i est enfin calculée en incrémentant pour chaque phase un compteur positif d'énergie $E_i+$ lorsque le terme $P_{i,1}$ calculé à l'aide de l'équation (1) est positif, et en incrémentant pour chaque phase un compteur négatif d'énergie $E_i-$ lorsque le terme $P_{i,1}$ est négatif. Le terme $P_{i,1}$ représente la puissance correspondant au produit du fondamental du courant et du fondamental de la tension. Les compteurs d'énergie $E_1+$, $E_1-$, $E_2+$, $E_2-$, $E_3+$, $E_3-$ sont incrémentés pour les trois phases de la tension triphasée, afin de calculer les énergies actives $E_1$, $E_2$, $E_3$ pour les trois phases de la tension triphasée.

Le premier module secondaire 62A élabore alors, lors de l'étape 350, son deuxième message M2A. Le deuxième message M2A contient l'identifiant du premier module secondaire 62A, les valeurs des six compteurs d'énergie $E_1-$, $E_2+$, $E_2-$, $E_3+$, $E_3-$ pour l'ensemble des trois phases de la tension triphasée et les coefficients complexes Re_j(IiA), Im_j(IiA) de la décomposition en série de Fourier des trois courants I1A, I2A, I3A jusqu'à l'harmonique K.

En complément, le deuxième message M2A contient les valeurs des moyennes quadratiques, également notées RMS, des courants I1A, I2A, I3A des trois phases, ainsi que les termes $P_{i,1}$ et $Q_{i,1}$ pour chacune des trois phases, et les valeurs $P_i$ et $Q_i$ pour chacune des trois phases.

Dans l'hypothèse où l'identifiant du premier module secondaire 62A était contenu dans le premier message M1 reçu précédemment, le premier module secondaire 62A émet alors lors de l'étape 360 son deuxième message M2A à l'aide de son logiciel d'émission 128A. Dans le cas contraire, le premier module secondaire 62A retourne directement à l'étape 310 de réception du premier message M1, et émettra son deuxième message M2A lorsque le premier message M1 contiendra son identifiant indiquant alors que l'unique jeton lui aura été attribué afin de l'autoriser à émettre son deuxième message M2A.

Après l'étape d'émission 360 dans le cas où le jeton avait été attribué au premier module secondaire 62A, ou bien après l'étape 350 autrement, le premier module secondaire 62A retourne à l'étape de réception 310 si le compteur a atteint la valeur correspondant à la période d'émission du premier message $P_{émission}$, ou bien à l'étape de mesure 330 autrement.

Les étapes du procédé de mesure mises en œuvre par les autres modules secondaires 62B, ..., 62N sont identiques aux étapes 300 à 360 décrites précédemment pour le premier module secondaire 62A, et sont réalisées en outre de manière simultanée entre tous les modules secondaires 62A, ..., 62N de par la synchronisation temporelle effectuée à l'aide du premier message M1.

Lors de l'étape d'émission 360, le seul module secondaire parmi l'ensemble des mesures secondaires 62A, ..., 62N autorisé à émettre son deuxième message est le module secondaire dont l'identifiant est contenu dans le premier message M1 reçu lors de l'étape de réception 310 précédente. Le logiciel de distribution 108 détermine selon un ordre croissant les identifiants contenus dans le premier message M1 afin d'attribuer successivement l'unique jeton aux modules secondaires 62A, ..., 62N. Autrement dit, chaque module secondaire 62A, ..., 62N émet toutes les N secondes son deuxième message M2A, ..., M2N respectif.

Comme représenté sur la figure 6, lors de l'étape 400, le module de centralisation 64 reçoit, à l'aide de son logiciel de réception 140, le premier message M1 du module primaire 60 et le deuxième message du module secondaire autorisé à émettre selon le mécanisme de jeton distribué, par exemple le message M2A.

Lors de l'étape 410, le module de centralisation 64 enregistre ensuite dans sa base de données 88 les valeurs reçues et contenues dans le premier message M1 et dans le deuxième message M2A, par l'intermédiaire de son logiciel d'enregistrement 142. En complément, le logiciel de traitement 144 effectue un horodatage des données enregistrées.

Le logiciel de traitement 144 calcule lors de l'étape suivante 420 le facteur de puissance $\cos(\varphi_i)$ pour chacune des trois phases numérotées i de la tension triphasée à l'aide de l'équation suivante :

$$\cos(\varphi_i) = \cos\left[\arctan\left(\frac{Q_{i,1}}{P_{i,1}}\right)\right] \tag{5}$$

Les grandeurs mesurées et calculées par le système de mesure sont ensuite affichées sur l'écran de l'interface homme-machine 90 du module de centralisation par l'intermédiaire du logiciel d'affichage 146 lors de l'étape 430. Ces grandeurs sont affichées sous forme de valeurs numériques et/ou sous forme de courbes.

Le module de centralisation 64 transmet enfin, lors de l'étape 440 et à l'aide de son logiciel de transmission 148, ces grandeurs mesurées et calculées au serveur distant, non représenté. Le serveur distant est propre à effectuer une gestion centralisée des grandeurs mesurées et calculées pour chaque système de mesure 20.

A l'issue de l'étape 440, le module de centralisation 64 retourne à l'étape 400, afin de recevoir le prochain premier message M1 du module primaire et le deuxième message du module secondaire autorisé à émettre la prochaine fois selon le mécanisme de jeton distribué, par exemple le message M2A.

Le système de mesure 20 selon l'invention est ainsi moins complexe et moins coûteux que le système de mesure de l'état de la technique puisque les modules secondaires 62A, ..., 62N sont prévus pour mesurer seulement l'intensité de chaque phase du courant triphasé circulant dans les conducteurs secondaires correspondant sans mesurer la tension de chacune des phases. La tension de chaque phase est mesurée par le module primaire 60, puis transmise à chacun des modules secondaires 62A, ..., 62N. Chaque module secondaire 62A, ..., 62N utilise alors les valeurs de tension reçues du module primaire 60 en combinaison avec la valeur de l'intensité de chaque phase mesurée par son capteur de courant 76A, ..., 76N pour calculer l'énergie électrique $E_1$, $E_2$, $E_3$ de chaque phase du départ 40A, ..., 40N correspondant.

Le système de mesure 20 selon l'invention permet en outre d'obtenir une mesure très précise des énergies actives $E_1$, $E_2$, $E_3$ pour les trois phases du courant triphasé, de par la synchronisation temporelle de chaque capteur de courant 76A par rapport à l'organe de mesure de la tension 66.

La synchronisation temporelle est très précise, le décalage de synchronisation mesuré étant de l'ordre de plus ou moins 400 nanosecondes avec la technologie actuelle des émetteurs-récepteurs radioélectriques 70, 80A, ..., 80N, 92 et des unités de traitement d'information 68, 78A, ..., 78N, 86.

L'ensemble des modules 60, 62A, ..., 62N, 64 sont reliés entre eux par des liaisons radioélectriques par l'intermédiaire de leur émetteur-récepteur radioélectrique 70, 82A, ..., 82N, 92 respectif, ce qui permet de faciliter l'installation du système de mesure 20 dans le poste de transformation 10.

La compression des données relatives aux tensions et aux intensités mesurées à l'aide des logiciels de compression 104, 124A, ..., 124N permet de limiter la quantité de données transmises via les liaisons radioélectriques, et de limiter ainsi la propre consommation d'énergie du système de mesure 20. En outre, la compression des données permet de réduire la sensibilité du système de mesure 20 à des perturbations radioélectriques de type brouillage ou perturbation de compatibilité électromagnétique, également appelée perturbation CEM.

L'émission du deuxième message M2A, ..., M2N selon un mécanisme de jeton distribué permet de réduire les interférences radioélectriques entre les modules secondaires 62A, ..., 62N.

Selon un autre mode de réalisation, non représenté, le module primaire 60 et le module de centralisation 64 sont regroupés dans un même module commun, ce qui permet d'avoir un unique émetteur-récepteur radioélectrique pour le module commun en lieu et place des deux émetteurs-récepteurs radioélectriques 70, 92 du module primaire et du module de centralisation.

Les autres avantages de ce deuxième mode de réalisation sont identiques à ceux du premier mode de réalisation décrit précédemment.

Le fonctionnement de ce deuxième mode de réalisation est par ailleurs identique à celui du premier mode de réalisation décrit précédemment.

Le fonctionnement du système de mesure 20 selon un autre mode de réalisation va désormais être expliqué.

Pour chaque capteur de courant 76A, la circulation du courant à travers le conducteur secondaire de départ correspondant est propre à engendrer un signal proportionnel à l'intensité du courant dans le premier enroulement 112A.

Sur la figure 4, lors de la première étape 200, le module primaire 60 s'initialise et mesure la fréquence F de la tension triphasée des conducteurs primaires 34, 36, 38 par l'intermédiaire du logiciel de mesure 102. La fréquence F de la tension triphasée est égale à la fréquence du réseau, telle que 50 Hz par exemple en Europe et 60 Hz par exemple aux Etats Unis.

Le module primaire 60 mesure ensuite, lors de l'étape 210, les première, deuxième et troisième tensions V1, V2, V3 à l'aide de son organe de mesure 66 et de son logiciel de mesure 102. Le logiciel 102 échantillonne en outre les valeurs mesurées des tensions V1, V2, V3. La fréquence $F_{ech}$ d'échantillonnage de la tension mesurée est un multiple de la fréquence F de la tension triphasée égale à l'inverse de la période $P_{tension}$ de ladite tension triphasée mesurée précédemment lors de l'étape 200. La période $P_{tension}$ de la tension triphasée est égale à la période du réseau, soit environ 20 ms en Europe et environ 16,66 ms aux Etats Unis.

Lors de l'étape 210, afin d'optimiser la précision de la mesure de l'énergie, la période $P_{tension}$ de la tension est mesurée régulièrement afin de prendre en compte des variations dans le temps de celle-ci, par exemple toutes les 10 secondes.

Lors de l'étape 220, les coefficients de la décomposition en série de Fourier de chacune des tensions V1, V2, V3 des trois phases sont calculés de manière identique à ce qui a été décrit pour le premier mode de réalisation.

Enfin, lors de l'étape 230, le module primaire 60 émet le premier message M1 à destination de chacun des modules secondaires 62A, ..., 62N et du module de centralisation 64. Le premier message M1 est de préférence émis périodiquement. La période d'émission $P_{émission}$ est prédéterminée, et de préférence égale à une seconde.

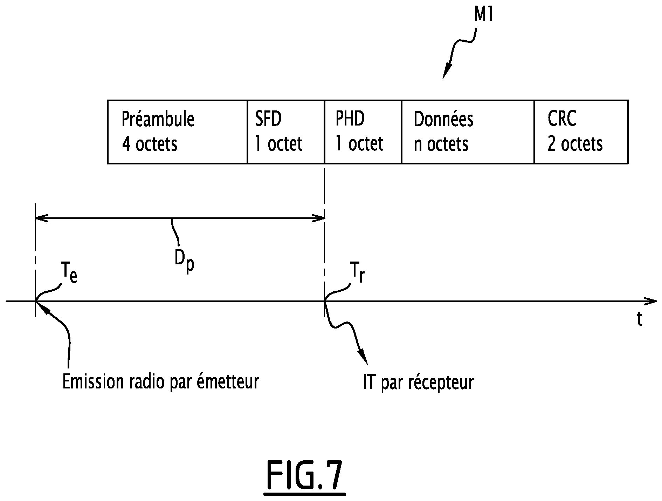

Le premier message M1 comprend un champ d'en-tête, également appelé préambule, un champ SFD (de l'anglais Start of Frame Delimiter), un champ PHR (de l'anglais Physical Header), un champ de données et un champ CRC (de l'anglais Cyclic Redundancy Check). Le préambule présente une taille de 4 octets, les champs SFD et PHR présentent chacun une taille d'un octet, le champ de données est de taille variable, notée n octets, et le champ CRC a une taille de 2 octets. Dans l'exemple de réalisation de la figure 7, le premier message M1 est constitué du champ d'en-tête, du champ SFD, du champ PHR, du champ de données et du champ CRC.

Le champ de données du premier message M1 contient notamment la période d'échantillonnage $P_{ech}$, les coefficients Re_j(Vi), Im_j(Vi) des décompositions en série de Fourier des trois tensions V1, V2, V3 jusqu'à l'harmonique K, calculés précédemment lors de l'étape 220, et l'identifiant du module secondaire qui sera autorisé à émettre son deuxième message à destination du module de centralisation 64 après la réception du premier message M1. L'identifiant du module secondaire autorisé à émettre ses informations de mesure est déterminé à l'aide du logiciel de distribution du jeton unique 108, l'identifiant du module contenu dans le premier message M1 permettant de désigner le module secondaire à qui l'unique jeton a été attribué.

En complément, le champ de données du premier message M1 contient les valeurs des moyennes quadratiques, également notées RMS (de l'anglais *Root Mean Square*), de chacune des trois tensions V1, V2, V3.

Lors de l'étape 300, le premier module secondaire 62A s'initialise et ouvre la fenêtre glissante de réception du premier message M1 à l'aide de son logiciel de réception 120A.

Lors de la réception du premier message M1, le premier module secondaire 62A détecte l'instant Tr de réception du champ SFD, la réception du champ SFD entrainant le déclenchement d'une interruption par le récepteur radioélectrique du premier module secondaire 62A. La détection de l'instant de réception Tr permet alors de calculer l'instant Te auquel le premier message M1 a été émis par l'émetteur radioélectrique du module primaire 60. L'instant d'émission Te est en effet égal à l'instant de réception Tr moins une durée Dp de propagation du premier message M1 via la liaison radioélectrique entre le module primaire 60 et le module secondaire correspondant, la durée de propagation Dp étant fixe et connue pour une taille prédéterminée du champ de données du premier message M1. Le premier module secondaire 62A passe alors à l'étape 320 de synchronisation temporelle avec le module primaire 60.

Lors de l'étape 320, le logiciel de synchronisation 122A procède de manière analogue à ce qui a été décrit pour le premier mode de réalisation.

L'instant de début de l'échantillonnage est ainsi réinitialisé afin d'assurer la synchronisation temporelle de l'unité de traitement de l'information 78A par rapport à l'organe de mesure de la tension 66.

Si le premier message M1 n'est pas détecté par le premier module secondaire 62A, la fenêtre de réception est refermée et aucune resynchronisation n'est effectuée. Le module secondaire 62A continue alors l'échantillonnage, tel qu'effectué lors de l'étape 340 du cycle précédent, jusqu'à ce qu'un nouveau message M1 soit reçu et permette alors d'effectuer la resynchronisation. Ainsi, la précision de mesure est susceptible d'être très légèrement dégradée d'un point de vue temporel, mais le système reste fonctionnel en l'absence de réception de quelques messages M1. Autrement dit, le système de mesure 20 est robuste à une absence temporaire de réception du premier message M1.

Le logiciel de compression 124A procède, lors de l'étape 340, de manière analogue à ce qui a été décrit pour le premier mode de réalisation.

Le logiciel de calcul 126A calcule alors de manière périodique les énergies actives E1+, E2+, E3+, E1-, E2-, E3- pour chacune des trois phases à partir des valeurs des tensions V1, V2, V3 mesurées reçues du module primaire 60 via le premier message M1 et des valeurs des intensités I1A, I2A, I3A mesurées par les capteurs de courant 76A.

Pour chaque phase i, une première Ei+ et une deuxième Ei- énergies actives sont calculées. La première énergie active Ei+ est le cumul de l'énergie électrique consommée par une charge connectée à la phase i en aval du module secondaire correspondant. La deuxième énergie active Ei- est le cumul de l'énergie électrique produite par un générateur connecté à la phase i en aval du module secondaire correspondant. La période de calcul des énergies actives E1+, E2+, E3+, E1-, E2-, E3- est égale à la période $P_{tension}$, soit par exemple environ 20 ms en Europe et environ 16,66 ms aux Etats Unis.

De manière analogue au premier mode de réalisation, les variations des tensions V1, V2, V3 sont suffisamment limitées entre deux instants d'émission du premier message M1 pour permettre le calcul des énergies actives E1+, E2+, E3+, E1-, E2-, E3-toutes les 20 ms, à partir des valeurs des intensités I1A, I2A, I3A mesurées toutes les 20 ms et des valeurs des tensions V1, V2, V3 reçues toutes les secondes.

Les puissances actives $P_i$ et réactives $Q_i$ sont calculées de manière identique à ce qui a été décrit pour le premier mode de réalisation à l'aide des équations (1) à (4), et étant donné que les premiers coefficients des décompositions en série de Fourier de chacune des tensions V1, V2, V3, d'une part, et les premiers coefficients des décompositions en série de Fourier de chacune des tensions I1A, I2A, I3A, d'autre part, sont calculés avec une simultanéité des échantillonnages, c'est-à-dire des échantillonnages débutant au même instant compte tenu de la resynchronisation de l'échantillonnage lors de l'étape 320 et présentant une même fréquence d'échantillonnage $F_{ech}$.

A chaque période $P_{tension}$, la première énergie active Ei+ est incrémentée uniquement lorsque $P_{i,1}$ est positif, c'est-à-dire que la puissance correspondant au produit du fondamental du courant et du fondamental de la tension est positive, ce qui correspond à une puissance consommée par une charge en aval du système de mesure.

Un incrément de la première énergie active AEi+ est alors égal au produit de la période $P_{tension}$ avec la puissance active $P_{i,1}$ calculée sur la dernière période, suivant l'équation suivante :

$$\Delta E_{i+} = P_{tension} \times P_{i,1} \qquad \text{avec} \qquad P_{i,1} > 0 \qquad\qquad (6)$$

A chaque période $P_{tension}$, la deuxième énergie active Ei- est incrémentée uniquement lorsque $P_{i,1}$ est négatif, c'est-à-dire que la puissance correspondant au produit du fondamental du courant et du fondamental de la tension est négative, ce qui correspond à une puissance fournie par un générateur en aval du système de mesure.

Un incrément de la deuxième énergie active AEi- est alors égal au produit de la période $P_{tension}$ avec la puissance active $P_{i,1}$ calculée sur la dernière période, suivant l'équation suivante :

$$\Delta E_{i-} = P_{tension} \times P_{i,1} \qquad \text{avec} \qquad P_{i,1} < 0 \qquad\qquad (7)$$

Pour un réseau électrique triphasé, le système de mesure 20 incrémente donc en permanence six compteurs d'énergie : E1+, E1-, E2+, E2-, E3+ et E3-. Ainsi les énergies produites et consommées sont bien distinctes. Le système de mesure 20 est également adapté pour mesurer l'énergie fournie par des générateurs d'énergie répartis sur le réseau électrique.

De manière identique au premier mode de réalisation, le deuxième message M2A contient l'identifiant du premier module secondaire 62A, les valeurs des six compteurs d'énergie $E_1$-, $E_2$+, $E_2$-, $E_3$+, $E_3$- pour l'ensemble des trois phases de la tension triphasée et les coefficients complexes Re_j(IiA), Im_j(IiA) de la décomposition en série de Fourier des trois courants I1A, I2A, I3A jusqu'à l'harmonique K.

En complément, le deuxième message M2A contient les valeurs des moyennes quadratiques, également notées RMS, des courants I1A, I2A, I3A des trois phases, ainsi que les termes $P_{i,1}$ et $Q_{i,1}$ pour chacune des trois phases, et les valeurs $P_i$ et $Q_i$ pour chacune des trois phases.

Les étapes 400 à 420 sont identiques à celles décrites pour le premier mode de réalisation, le module de centralisation 64 enregistrant dans sa base de données 88 les valeurs reçues et contenues dans le premier message M1 et dans les deuxièmes messages M2A,...M2N.

En complément, lors de l'étape 420, le logiciel de traitement 144 calcule diverses composantes caractérisant la tension triphasée du réseau, à savoir des tensions fondamentales complexes V11, V12 et V13, une composante homopolaire V0, une composante directe Vd, une composante inverse Vi et un déséquilibre $\Delta$ à l'aide des équations suivantes :

$$V11 = \text{Re}\_1(V1) + j \times \text{Im}\_1(V1) \qquad\qquad (8)$$

$$V12 = \mathrm{Re\_1}(V2) + j \times \mathrm{Im\_1}(V2) \tag{9}$$

$$V13 = \mathrm{Re\_1}(V3) + j \times \mathrm{Im\_1}(V3) \tag{10}$$

$$V0 = \frac{1}{3}\left(V11 + V12 + V13\right) \tag{11}$$

$$Vd = \frac{1}{3}\left(V11 + a \times V12 + a^2 \times V13\right) \tag{12}$$

où a est un opérateur de rotation défini par :

$$a = e^{j2\pi/3} \tag{13}$$

$$Vi = \frac{1}{3}\left(V11 + a^2 \times V12 + a \times V13\right) \tag{14}$$

$$\Delta = \left|\frac{Vi}{Vd}\right| \tag{15}$$

La composante homopolaire V0 est nulle si le réseau ne présente aucun défaut.

Dans l'exemple de réalisation des figures 1 à 7 décrit précédemment, le réseau électrique 12 est un réseau triphasé, et le courant mesuré par l'intermédiaire du système de mesure 20 est un courant triphasé. L'homme du métier comprendra bien entendu que l'invention s'applique également à un réseau électrique monophasé et à la mesure d'un courant alternatif monophasé.

On conçoit ainsi que le système de mesure 20 selon l'invention est plus précis, moins complexe et moins coûteux.

## Revendications

1. - Système (20) de mesure de l'énergie électrique du courant circulant dans au moins un conducteur électrique secondaire (42A, 44A, 46A, 42B, 44B, 46B, ..., 42N, 44N, 46N), le conducteur secondaire (42A, 42B, ..., 42N ; 44A, 44B, ..., 44N ; 46A, 46B, ..., 46N) étant relié électriquement à un conducteur électrique primaire (34 ; 36 ; 38), le conducteur primaire (34 ; 36 ; 38) et le ou chaque conducteur secondaire (42A, 42B, ..., 42N ; 44A, 44B, ..., 44N ; 46A, 46B, ..., 46N) présentant sensiblement la même tension (V1 ; V2 ; V3), ce système de mesure comprenant :

   - un module primaire (60) comportant un émetteur radioélectrique (70) et un organe (66) de mesure de la tension du conducteur primaire (34, 36, 38),
   - au moins un module secondaire (62A, ..., 62N) comportant un récepteur radioélectrique (80A, ..., 80N), un capteur (76A, ..., 76N) de l'intensité (I1A, I2A, I3A, I1B, I2B, I3B, ..., I1N, I2N, I3N) du courant circulant dans le conducteur secondaire (42A, 44A, 46A, 42B, 44B, 46B, ..., 42N, 44N, 46N) correspondant et un organe (126A, ..., 126N) de calcul de l'énergie électrique ($E_1$, $E_2$, $E_3$, $E_1$-, $E_2$+, $E_2$-, $E_3$+, $E_3$-) dudit courant circulant dans le conducteur secondaire (42A, 44A, 46A, 42B, 44B, 46B, ..., 42N, 44N, 46N) correspondant,

   **caractérisé en ce que**

   - le module primaire (60) comporte des premiers moyens (104) de compression de la valeur de la tension mesurée (V1, V2, V3) et des moyens (106) d'émission, depuis l'émetteur radioélectrique (70) à destination du récepteur radioélectrique (80A, ..., 80N) du ou de chaque module secondaire (62A, 62B, ..., 62N), d'un premier message (M1) contenant la valeur compressée de la tension mesurée par l'organe de mesure (66),
   - le système de mesure (20) comprend des moyens (106, 120A, ..., 120N, 122A, ..., 122N) de synchronisation temporelle du ou de chaque capteur de l'intensité (76A, ..., 76N) par rapport à l'organe de mesure de la tension (66), et

- l'organe de calcul (126A, ..., 126N) est relié au récepteur radioélectrique (80A, ..., 80N) et propre à calculer l'énergie électrique à partir de la valeur de la tension (V1, V2, V3) mesurée reçue du module primaire (60) et de la valeur de l'intensité (I1A, ..., I3N) mesurée par le capteur de l'intensité (76A, ..., 76N), et

**en ce que** le premier message (M1) comporte une donnée de synchronisation pour la synchronisation temporelle du ou de chaque capteur de l'intensité (76A, ..., 76N) par rapport à l'organe de mesure de la tension (66), la date de réception du premier message (M1) étant la date de référence pour la synchronisation de l'au moins un module secondaire (62A, ..., 62N) par rapport au module primaire (60), l'au moins un module secondaire (62A, ..., 62N) étant propre à vérifier que le premier message (M1) contient la donnée de synchronisation pour effectuer ensuite la synchronisation temporelle avec le module primaire (60).

2. - Système (20) selon la revendication 1, dans lequel le ou chaque module secondaire (62A, ..., 62N) est prévu pour mesurer seulement l'intensité (I1A, I2A, I3A, I1B, I2B, I3B, ..., I1N, I2N, I3N) du courant circulant dans le conducteur secondaire (42A, 44A, 46A, ..., 42N, 44N, 46N) correspondant, sans mesurer la tension dudit courant circulant dans le conducteur secondaire correspondant.

3. - Système (20) selon l'une quelconque des revendications précédentes, dans lequel les premiers moyens de compression (104) comportent des premiers moyens de calcul de coefficients ($Re\_j (Vi), Im\_j (Vi)$ ; i = 1, 2, 3 ; j compris entre 1 et K) de la décomposition en série de Fourier de ladite valeur de la tension mesurée par l'organe de mesure (66) du module primaire (60).

4. - Système (20) selon l'une quelconque des revendications précédentes, dans lequel le ou chaque module secondaire (62A, ..., 62N) comporte des deuxièmes moyens (124A, ..., 124N) de compression de la valeur de l'intensité mesurée (I1A, I2B, I3A, ..., I3N).

5. - Système (20) selon la revendication 4, dans lequel les deuxièmes moyens de compression (124A, ..., 124N) comportent des deuxièmes moyens de calcul de coefficients ($Re\_j(IiA), Im\_j (IiA), ..., Re\_j (IiN), Im\_j (IiN)$; i = 1, 2, 3 ; j compris entre 1 et K) de la décomposition en série de Fourier de ladite valeur de l'intensité mesuré par le capteur (76A, ..., 76N) du module secondaire (62A, ..., 62N).

6. - Système (20) selon l'une quelconque des revendications précédentes prise avec la revendication 4, dans lequel l'organe de calcul (126A, ..., 126N) est propre à calculer l'énergie électrique ($E_1, E_2, E_3, E_1\text{-}, E_2\text{+}, E_2\text{-}, E_3\text{+}, E_3\text{-}$) à partir des valeurs compressées de l'intensité mesurée et de la tension mesurée.

7. - Système (20) selon l'une quelconque des revendications précédentes, dans lequel le système comprend une pluralité de modules secondaires (62A, ..., 62N) et un module (64) de centralisation des valeurs d'énergie électrique ($E_1, E_2, E_3, E_1\text{-}, E_2\text{+}, E_2\text{-}, E_3\text{+}, E_3\text{-}$) calculées, le module de centralisation (64) comportant un récepteur radioélectrique (92), et chaque module secondaire (62A, ..., 62N) comporte des moyens (128A, ..., 128N) d'émission, depuis l'émetteur radioélectrique (80A, ..., 80N) à destination du récepteur radioélectrique (92) du module de centralisation (64), d'un deuxième message (M2A, ..., M2N) contenant la valeur de l'énergie ($E_1, E_2, E_3, E_1\text{-}, E_2\text{+}, E_2\text{-}, E_3\text{+}, E_3\text{-}$) calculée par l'organe de calcul (126A, ..., 126N).

8. - Système (20) selon la revendication 7, dans lequel le module primaire (60) comporte des moyens (108) de distribution d'un unique jeton aux modules secondaires (62A, ..., 62N) de manière successive et les moyens d'émission du module secondaire (62A, ..., 62N) sont propres à émettre le deuxième message (M2A, ..., M2N) seulement lorsque le module secondaire (62A, ..., 62N) correspondant a préalablement reçu l'unique jeton de la part du module primaire (60).

9. - Système (20) selon l'une quelconque des revendications précédentes prise avec la revendication 3 ou 5, dans lequel le premier message (M1) contient la valeur d'une période d'échantillonnage (Pech) à laquelle sont calculés des coefficients de la décomposition en série de Fourier de ladite valeur de la tension mesurée ($Re\_j (Vi), Im\_j (Vi)$ ; i = 1, 2, 3 ; j compris entre 1 et K) et/ou de ladite valeur de l'intensité mesuré ($Re\_j(IiA), Im\_j (IiA), ..., Re\_j (IiN), Im\_j (IiN)$; i = 1, 2, 3 ; j compris entre 1 et K).

10. - Poste (10) de transformation d'un courant électrique présentant une première tension alternative en un courant électrique présentant une deuxième tension alternative, comprenant :

- un premier tableau (14) comportant au moins un conducteur électrique d'arrivée (24A, 26A, 28A, 24B, 26B, 28B) propre à être relié à un réseau électrique (12), le conducteur d'arrivée présentant la première tension alternative,

- un deuxième tableau (16) comportant au moins un conducteur électrique primaire de départ (34, 36, 38) et au moins un conducteur électrique secondaire de départ (42A, 44A, 46A, 42B, 44B, 46B, ..., 42N, 44N, 46N), le ou chaque conducteur secondaire de départ (42A, 42B, .., 42N ; 44A, 44B, ..., 44N ; 46A, 46B, ..., 46N) étant connecté électriquement à un conducteur primaire de départ (34 ; 36 ; 38) correspondant, les conducteurs de départ (34, 42A, 42B, .., 42N ; 36, 44A, 44B, ..., 44N ; 38, 46A, 46B, ..., 46N) correspondants présentant la deuxième tension alternative,

- un transformateur électrique (18) connecté entre le premier tableau (14) et le deuxième tableau (16) et propre à transformer le courant présentant la première tension alternative en le courant présentant la deuxième tension alternative, et

- un système (20) de mesure de l'énergie électrique ($E_1$, $E_2$, $E_3$, $E_1$-, $E_2$+, $E_2$-, $E_3$+, $E_3$-) du courant circulant dans le ou chaque conducteur secondaire de départ (42A, 44A, 46A, 42B, 44B, 46B, ..., 42N, 44N, 46N),

**caractérisé en ce que** le système de mesure (20) est conforme à l'une quelconque des revendications précédentes.

11. Procédé de mesure de l'énergie électrique ($E_1$, $E_2$, $E_3$, $E_1$-, $E_2$+, $E_2$-, $E_3$+, $E_3$-) du courant circulant dans au moins un conducteur électrique secondaire (42A, 44A, 46A, 42B, 44B, 46B, ..., 42N, 44N, 46N), le conducteur secondaire (42A, 42B, .., 42N ; 44A, 44B, ..., 44N ; 46A, 46B, ..., 46N) étant relié électriquement à un conducteur électrique primaire (34 ; 36 ; 38), le conducteur primaire (34 ; 36 ; 38) et le ou chaque conducteur secondaire (42A, 42B, .., 42N ; 44A, 44B, ..., 44N ; 46A, 46B, ..., 46N) présentant sensiblement la même tension,

le procédé comprenant les étapes suivantes :

- (a) la mesure (210), par un module primaire (60), de la tension (V1, V2, V3) du courant circulant dans le conducteur primaire (34, 36, 38),
- (b) la mesure (330), par un module secondaire (62A, ..., 62N), de l'intensité (I1, I2A, I3A, ..., I3N) du courant circulant dans le conducteur secondaire (42A, 44A, 46A, 42B, 44B, 46B, ..., 42N, 44N, 46N) correspondant, et
- (c) le calcul (340), par le module secondaire (62A, ..., 62N), de l'énergie électrique ($E_1$, $E_2$, $E_3$, $E_1$-, $E_2$+, $E_2$-, $E_3$+, $E_3$-) dudit courant circulant dans le conducteur secondaire (42A, 44A, 46A, 42B, 44B, 46B, ..., 42N, 44N, 46N) correspondant,

**caractérisé en ce que** le procédé comprend en outre les étapes suivantes :

- (i) la compression (220) de la valeur de la tension mesurée (V1, V2, V3) et l'émission (230), par le module primaire (60), d'un premier message (M1) contenant la valeur compressée de la tension mesurée, via une liaison radioélectrique entre le module primaire (60) et le module secondaire (62A, ..., 62N), et
- (ii) la synchronisation temporelle (320) de la mesure de l'intensité avec la mesure de la tension,

**en ce que**, lors de l'étape (c), le calcul de l'énergie électrique ($E_1$, $E_2$, $E_3$, $E_1$-, $E_2$+, $E_2$-, $E_3$+, $E_3$-) est effectué à partir de la valeur de la tension mesurée reçue du module primaire (60) et de la valeur de l'intensité mesurée par le capteur de l'intensité (76A, ..., 76N), et

**en ce que** le premier message (M1) comporte une donnée de synchronisation pour la synchronisation temporelle du ou de chaque capteur de l'intensité (76A, ..., 76N) par rapport à l'organe de mesure de la tension (66), la date de réception du premier message (M1) étant la date de référence pour la synchronisation de l'au moins un module secondaire (62A, ..., 62N) par rapport au module primaire (60), et l'au moins un module secondaire (62A, ..., 62N) vérifie que le premier message (M1) contient la donnée de synchronisation pour effectuer ensuite la synchronisation temporelle avec le module primaire (60).

12. - Procédé selon la revendication 11, dans lequel la période ($P_{tension}$) de la tension (V1, V2, V3) est mesurée régulièrement par le module primaire (60), la période de mesure étant de préférence égale à 10 secondes.

**Patentansprüche**

1. - System (20) zum Messen der elektrischen Energie des Stroms, der durch mindestens einen elektrischen Sekundärleiter (42A, 44A, 46A, 42B, 44B, 46B, ..., 42N, 44N, 46N) fließt, wobei der Sekundärleiter (42A, 42B, ..., 42N; 44A, 44B, ..., 44N; 46A, 46B, ..., 46N) elektrisch mit einem elektrischen Primärleiter (34; 36; 38) verbunden ist, wobei der Primärleiter (34; 36; 38) und der oder jeder Sekundärleiter (42A, 42B, ..., 42N; 44A, 44B, ..., 44N; 46A, 46B, ..., 46N) im Wesentlichen die gleiche Spannung (V1; V2; V3) aufweisen, dieses Messsystem umfassend:

- ein Primärmodul (60), umfassend einen Funksender (70) und ein Element (66) zum Messen der Spannung des Primärleiters (34, 36, 38),
- mindestens ein Sekundärmodul (62A, ..., 62N), umfassend einen Funkempfänger (80A, ..., 80N), einen Sensor (76A, ..., 76N) der Stärke (I1A, I2A, I3A, I1B, I2B, I3B, ..., I1N, I2N, I3N) des Stroms, der in dem entsprechenden Sekundärleiter (42A, 44A, 46A, 42B, 44B, 46B, ..., 42N, 44N, 46N) fließt, und ein Element (126A, ..., 126N) zum Berechnen der elektrischen Energie ($E_1$, $E_2$, $E_3$, $E_1$-, $E_2$+, $E_2$-, $E_3$+, $E_3$-) des Stroms, der in dem entsprechenden Sekundärleiter (42A, 44A, 46A, 42B, 44B, 46B, ..., 42N, 44N, 46N) fließt, **dadurch gekennzeichnet, dass**

- das Primärmodul (60) erste Einrichtungen (104) zur Komprimierung des Werts der gemessenen Spannung (V1, V2, V3) und Einrichtungen (106) zum Senden, von dem Funksender (70) zu dem Funkempfänger (80A, ..., 80N) von dem oder jedem Sekundärmodul (62A, 62B, ..., 62N), einer ersten Nachricht (M1) umfasst, die den komprimierten Wert der Spannung enthält, die von dem Messelement (66) gemessen wird,
- das Messsystem (20) Einrichtungen (106, 120A, ..., 120N, 122A, ..., 122N) zur zeitlichen Synchronisation des oder jedes Sensors der Stärke (76A, ..., 76N) in Bezug auf das Messelement der Spannung (66) umfasst, und
- das Berechnungselement (126A, ..., 126N) mit dem Funkempfänger (80A, ..., 80N) verbunden und geeignet ist, um die elektrische Energie anhand des Werts der gemessenen Spannung (V1, V2, V3), die von dem Primärmodul (60) empfangen wird, und des Werts der Stärke (I1A, ..., I3N), die von dem Sensor der Stärke (76A, ..., 76N) gemessen wird, zu berechnen, und,

dass die erste Nachricht (M1) ein Synchronisationsdatum für die zeitliche Synchronisation des oder jedes Sensors der Stärke (76A, ..., 76N) in Bezug auf das Messelement der Spannung (66) umfasst, wobei das Empfangsdatum der ersten Nachricht (M1) das Bezugsdatum für die Synchronisation des mindestens einen Sekundärmoduls (62A, ..., 62N) in Bezug auf das Primärmodul (60) ist, wobei das mindestens eine Sekundärmodul (62A, ..., 62N) geeignet ist, um zu überprüfen, ob die erste Nachricht (M1) die Synchronisationsdaten enthält, um anschließend die zeitliche Synchronisation mit dem Primärmodul (60) durchzuführen.

**2.** - System (20) nach Anspruch 1, wobei das oder jedes Sekundärmodul (62A, ..., 62N) bereitgestellt ist, um nur die Stärke (I1A, I2A, I3A, I1B, I2B, I3B, ..., I1N, I2N, I3N) des Stroms zu messen, der in dem entsprechenden Sekundärleiter (42A, 44A, 46A, ..., 42N, 44N, 46N) fließt, ohne die Spannung des Stroms zu messen, der in dem entsprechenden Sekundärleiter fließt.

**3.** - System (20) nach einem der vorherigen Ansprüche, wobei die ersten Kompressionseinrichtungen (104) erste Einrichtungen zum Berechnen von Koeffizienten (Re_j (Vi), Im_j (Vi); i = 1, 2, 3; j zwischen 1 und K) der Fourier-Reihenzerlegung des Werts der gemessenen Spannung umfassen, der von dem Messelement (66) des Primärmoduls (60) gemessen wurde.

**4.** - System (20) nach einem der vorherigen Ansprüche, wobei das oder jedes Sekundärmodul (62A, ..., 62N) zweite Einrichtungen (124A, ..., 124N) zum Komprimieren des Werts der gemessenen Stärke (I1A, I2B, I3A, ..., I3N) umfasst.

**5.** - System (20) nach Anspruch 4, wobei die zweiten Kompressionseinrichtungen (124A, ..., 124N) zweite Einrichtungen zum Berechnen von Koeffizienten (Re_j(IiA), Im_j (IiA), ..., Re_j (IiN), Im_j (IiN); i = 1, 2, 3; j zwischen 1 und K) der Fourier-Reihenzerlegung des Werts der Stärke umfassen, die von dem Sensor (76A, ..., 76N) des Sekundärmoduls (62A, ..., 62N) gemessen wird.

**6.** - System (20) nach einem der vorherigen Ansprüche in Verbindung mit Anspruch 4, wobei das Berechnungselement (126A, ..., 126N) dazu geeignet ist, um die elektrische Energie ($E_1$, $E_2$, $E_3$, $E_1$-, $E_2$+, $E_2$-, $E_3$+, $E_3$-) anhand der komprimierten Werte der gemessenen Stärke und der gemessenen Spannung zu berechnen.

**7.** - System (20) nach einem der vorherigen Ansprüche, wobei das System eine Vielzahl von Sekundärmodulen (62A, ..., 62N) und ein Modul (64) zum Zentralisieren der berechneten Werte der elektrischen Energie ($E_1$, $E_2$, $E_3$, $E_1$-, $E_2$+, $E_2$-, $E_3$+, $E_3$-) umfasst, das Zentralisierungsmodul (64) umfassend einen Funkempfänger

(92), und jedes Sekundärmodul (62A, ..., 62N) umfassend Einrichtungen (128A, ..., 128N) zum Senden, von dem Funksender (80A, ..., 80N) an den Funkempfänger (92) des Zentralisierungsmoduls (64), einer zweiten Nachricht (M2A, ..., M2N), die den Wert der Energie ($E_1$, $E_2$, $E_3$, $E_1$-, $E_2$+, $E_2$-, $E_3$+, $E_3$-) enthält, der von dem Berechnungselement (126A, ..., 126N) berechnet wird.

8. - System (20) nach Anspruch 7, wobei das Primärmodul (60) Einrichtungen (108) zur Verteilung eines einzigen Tokens an die Sekundärmodule (62A, ..., 62N) auf aufeinanderfolgende Weise umfasst und die Sendeeinrichtungen des Sekundärmoduls (62A, ..., 62N) geeignet sind, um die zweite Nachricht (M2A, ..., M2N) nur dann zu senden, wenn das entsprechende Sekundärmodul (62A, ..., 62N) zuvor das einzige Token von dem Primärmodul (60) erhalten hat.

9. - System (20) nach einem der vorherigen Ansprüche in Verbindung mit Anspruch 3 oder 5, wobei die erste Nachricht (M1) den Wert einer Abtastperiode (Pech) enthält, bei der Koeffizienten der Fourier-Reihenzerlegung des Werts der gemessenen Spannung (Re_j (Vi), lm_j (Vi); i = 1, 2, 3; j zwischen 1 und K) und/oder des Werts der gemessenen Stärke (Re_j(IiA), lm_j (IiA), ..., Re_j (IiN), lm_j (IiN); i = 1, 2, 3; j zwischen 1 und K) berechnet werden.

10. - Station (10) zum Umwandeln eines elektrischen Stroms, der eine erste Wechselspannung aufweist, in einen elektrischen Strom der eine zweite Wechselspannung aufweist, umfassend:

   - eine erste Tafel (14), umfassend mindestens einen ankommenden elektrischen Leiter (24A, 26A, 28A, 24B, 26B, 28B), der geeignet ist, um mit einem Stromnetz (12) verbunden zu werden, wobei der ankommende Leiter die erste Wechselspannung aufweist,
   - eine zweite Tafel (16), umfassend mindestens einen primären elektrischen Abgangsleiter (34, 36, 38) und mindestens einen sekundären elektrischen Abgangsleiter (42A, 44A, 46A, 42B, 44B, 46B, ..., 42N, 44N, 46N), wobei der oder jeder sekundäre Abgangsleiter (42A, 42B, ..., 42N; 44A, 44B, ..., 44N; 46A, 46B, ..., 46N) elektrisch mit einem entsprechenden primären Abgangsleiter (34; 36; 38) verbunden ist, wobei die entsprechenden Abgangsleiter (34, 42A, 42B, ..., 42N; 36, 44A, 44B, ..., 44N; 38, 46A, 46B, ..., 46N) die zweite Wechselspannung aufweisen,
   - einen elektrischen Transformator (18), der zwischen der ersten Tafel (14) und der zweiten Tafel (16) angeschlossen ist und geeignet ist, um den Strom, der die erste Wechselspannung aufweist in den Strom umzuwandeln, der die zweite Wechselspannung aufweist, und
   - ein System (20) zum Messen der elektrischen Energie ($E_1$, $E_2$, $E_3$, $E_1$-, $E_2$+, $E_2$-, $E_3$+, $E_3$-) des Stroms, der in dem oder jedem sekundären Abgangsleiter (42A, 44A, 46A, 42B, 44B, 46B, ..., 42N, 44N, 46N) fließt,

   **dadurch gekennzeichnet, dass** das Messsystem (20) gemäß einem der vorherigen Ansprüche ist.

11. Verfahren zum Messen der elektrischen Energie ($E_1$, $E_2$, $E_3$, $E_1$-, $E_2$+, $E_2$-, $E_3$+, $E_3$-) des Stroms, der in mindestens einem elektrischen Sekundärleiter (42A, 44A, 46A, 42B, 44B, 46B, ..., 42N, 44N, 46N) fließt, wobei der Sekundärleiter (42A, 42B, ..., 42N; 44A, 44B, ..., 44N; 46A, 46B, ..., 46N) elektrisch mit einem elektrischen Primärleiter (34; 36; 38) verbunden ist, wobei der Primärleiter (34; 36; 38) und der oder jeder Sekundärleiter (42A, 42B, ..., 42N; 44A, 44B, ..., 44N; 46A, 46B, ..., 46N) im Wesentlichen die gleiche Spannung aufweisen, das Verfahren umfassend die folgenden Schritte:

   - (a) Messen (210), durch ein Primärmodul (60), der Spannung (V1, V2, V3) des Stroms, der in dem Primärleiter (34, 36, 38) fließt,
   - (b) Messen (330), durch ein Sekundärmodul (62A, ..., 62N), der Stärke (I1, I2A, I3A, ..., I3N) des Stroms, der in dem entsprechenden Sekundärleiter (42A, 44A, 46A, 42B, 44B, 46B, ..., 42N, 44N, 46N) fließt, und
   - (c) Berechnen (340), durch das Sekundärmodul (62A, ..., 62N), der elektrischen Energie ($E_1$, $E_2$, $E_3$, $E_1$-, $E_2$+, $E_2$-, $E_3$+, $E_3$-) des Stroms, der in dem entsprechenden Sekundärleiter (42A, 44A, 46A, 42B, 44B, 46B, ..., 42N, 44N, 46N) fließt,

   **dadurch gekennzeichnet, dass** das Verfahren ferner die folgenden Schritte umfasst:

   - (i) Komprimieren (220) des Werts der gemessenen Spannung (V1, V2, V3) und Senden (230), durch das Primärmodul (60), einer ersten Nachricht (M1), die den komprimierten Wert der gemessenen Spannung enthält, über eine Funkverbindung zwischen dem Primärmodul (60) und dem Sekundärmodul (62A, ..., 62N), und
   - (ii) zeitliches Synchronisieren (320) der Messung der Stärke mit der Messung der Spannung,

dass in Schritt (c) das Berechnen der elektrischen Energie ($E_1$, $E_2$, $E_3$, $E_1$-, $E_2$+, $E_2$-, $E_3$+, $E_3$-) anhand des Werts der gemessenen Spannung, die von dem Primärmodul (60) empfangen wird, und des Werts der Stärke, die von dem Sensor der Stärke (76A, ..., 76N) gemessen wird, durchgeführt wird, und,

dass die erste Nachricht (M1) ein Synchronisationsdatum für die zeitliche Synchronisation des oder jedes Sensors der Stärke (76A, ..., 76N) in Bezug auf das Messelement der Spannung (66) umfasst, wobei das Empfangsdatum der ersten

Nachricht (M1) das Bezugsdatum für die Synchronisation des mindestens einen Sekundärmoduls (62A, ..., 62N) in Bezug auf das Primärmodul (60) ist, und das mindestens eine Sekundärmodul (62A, ..., 62N) überprüft, ob die erste Nachricht (M1) die Synchronisationsdaten enthält, um dann die Zeitsynchronisation mit dem Primärmodul (60) durchzuführen.

**12.** - Verfahren nach Anspruch 11, wobei dem die Periode ($P_{Spannung}$) der Spannung (V1, V2, V3) regelmäßig durch das Primärmodul (60) gemessen wird, wobei die Messperiode vorzugsweise 10 Sekunden ist.

## Claims

**1.** - System (20) for measuring the electrical power of the current flowing in at least one secondary electrical conductor (42A, 44A, 46A, 42B, 44B, 46B, ..., 42N, 44N, 46N), the secondary conductor (42A, 42B, ..., 42N; 44A, 44B, ..., 44N; 46A, 46B, ..., 46N) being electrically connected to a primary electrical conductor (34; 36; 38), the primary conductor (34; 36; 38) and the or each secondary conductor (42A, 42B, ..., 42N; 44A, 44B, ..., 44N; 46A, 46B, ..., 46N) having substantially the same voltage (V1; V2; V3), with this measurement system comprising:

- a primary module (60) comprising a radioelectric emitter (70) and a unit (66) for measuring the voltage of the primary conductor (34, 36, 38),
- at least one secondary module (62A, ..., 62N) comprising a radioelectric receiver (80A, ..., 80N), a sensor (76A, ..., 76N) of the intensity (I1A, I2A, I3A, I1B, I2B, I3B, ..., I1N, I2N, I3N) of the current flowing in the corresponding secondary conductor (42A, 44A, 46A, 42B, 44B, 46B, ..., 42N, 44N, 46N) and a unit (126A, ..., 126N) for calculating the electrical power ($E_1$, $E_2$, $E_3$, $E_1$-, $E_2$+, $E_2$-, $E_3$+, $E_3$-) of said current flowing in the corresponding secondary conductor (42A, 44A, 46A, 42B, 44B, 46B, ..., 42N, 44N, 46N),

**characterised in that**

- the primary module (60) comprises first means (104) of compression of the measured value of the voltage (V1, V2, V3) and means (106) of emitting, from the radioelectric emitter (70) to the radioelectric receiver (80A, ..., 80N) of the or of each secondary module (62A, 62B, ..., 62N), a first message (M1) containing the compressed value of the voltage measured by the unit for measuring (66),
- the measurement system (20) comprises means (106, 120A, ..., 120N, 122A, ..., 122N) for the temporal synchronisation of the or of each intensity sensor (76A, ..., 76N) in relation to the unit for measuring voltage (66), and
- the calculating unit (126A, ..., 126N) is connected to the radioelectric receiver (80A, ..., 80N) and able to calculate the electrical power from the value of the measured voltage (V1, V2, V3) received from the primary module (60) and from the value of the intensity (I1A, ..., I3N) measured by the intensity sensor (76A, ..., 76N), and

**In that** the first message (M1) comprises synchronisation data for the temporal synchronisation of the or of each intensity sensor (76A, ..., 76N) in relation to the unit for measuring voltage (66), the date of reception of the first message (M1) being the date of reference for the synchronisation of the at least one first secondary module (62A,...,62N) in relation to primary module (60), the at least one first secondary module (62A,...,62N) being able to check that the first message (M1) contains the synchronisation data and to then carry out the temporal synchronisation with the primary module (60).

**2.** - System (20) according to claim 1, wherein the or each secondary module (62A, ..., 62N) is provided to measure only the intensity (I1A, I2A, I3A, I1B, I2B, I3B, ..., I1N, I2N, I3N) of the current flowing in the corresponding secondary conductor (42A, 44A, 46A, ..., 42N, 44N, 46N), without measuring the voltage of said current flowing in the corresponding secondary conductor.

**3.** - System (20) as claimed in any preceding claim, wherein the first means of compression (104) comprise first means of calculating coefficients ($Re\_j$ ($Vi$), $Im\_j$ ($Vi$); $i = 1, 2, 3$; $j$ between 1 and K) of the decomposition into Fourier series of said value of the voltage measured by the unit for measuring (66) of the primary module (60).

4. - System (20) as claimed in any preceding claim, wherein the or each secondary module (62A, ..., 62N) comprises second means (124A, ..., 124N) of compression of the measured value of the intensity (I1A, I2B, I3A, ..., I3N).

5. - System (20) according to claim 4, wherein the second means of compression (124A, ..., 124N) comprise second means of calculating coefficients (Re_j(IiA), Im_j (IiA), ..., Re_j (IiN), Im_j (IiN); i = 1, 2, 3; j between 1 and K) of the decomposition into Fourier series of said measured value of the intensity by the sensor (76A, ..., 76N) of the secondary module (62A, ..., 62N).

6. - System (20) as claimed in any preceding claim taken with claim 4, wherein the calculating unit (126A, ..., 126N) is able to calculate the electrical power ($E_1$, $E_2$, $E_3$, $E_1$-, $E_2$+, $E_2$-, $E_3$+, $E_3$-) from the compressed values of the measured intensity and of the measured voltage.

7. - System (20) as claimed in any preceding claim, wherein the system comprises a plurality of secondary modules (62A, ..., 62N) and a module (64) for centralising calculated values of electrical power ($E_1$, $E_2$, $E_3$, $E_1$-, $E_2$+, $E_2$-, $E_3$+, $E_3$-), the centralisation module (64) comprising a radioelectric receiver (92), and each secondary module (62A, ..., 62N) comprises means (128A, ..., 128N) for emitting, from the radioelectric emitter (80A, ..., 80N) to the radioelectric receiver (92) of the centralisation module (64), a second message (M2A, ..., M2N) containing the value of the power ($E_1$, $E_2$, $E_3$, $E_1$-, $E_2$+, $E_2$-, $E_3$+, $E_3$-) calculated by the calculating unit (126A, ..., 126N).

8. - System (20) according to claim 7, wherein the primary module (60) comprises means (108) for distributing a unique token to the secondary modules (62A, ..., 62N) successively and the means of emitting of the secondary module (62A, ..., 62N) are able to emit the second message (M2A, ..., M2N) only when the corresponding secondary module (62A, ..., 62N) has received beforehand the unique token from the primary module (60).

9. - System (20) as claimed in any preceding claim taken with claim 3 or 5, wherein the first message (M1) contains the value of a sampling period (Psamp) at which are calculated coefficients for the decomposition into Fourier series of said measured value of the voltage (Re_j (Vi), lm_j (Vi); i = 1, 2, 3; j between 1 and K) and/or of said measured value of the intensity (Re_j(IiA), lm_j (IiA), ..., Re_j (IiN), lm_j (IiN); i = 1, 2, 3; j between 1 and K).

10. - Unit (10) for transforming an electrical current having a first alternating voltage into an electrical current having a second alternating voltage, comprising:

 - a first panel (14) comprising at least one inlet electrical conductor (24A, 26A, 28A, 24B, 26B, 28B) able to be connected to an electrical network (12), with the inlet conductor having the first alternating voltage,
 - a second panel (16) comprising at least one primary outlet electrical conductor (34, 36, 38) and at least one secondary outlet electrical conductor (42A, 44A, 46A, 42B, 44B, 46B, ..., 42N, 44N, 46N), the or each secondary outlet conductor (42A, 42B, .., 42N; 44A, 44B, ..., 44N; 46A, 46B, ..., 46N) being connected electrically to a corresponding outlet primary conductor (34; 36; 38), with the corresponding outlet conductors (34, 42A, 42B, .., 42N; 36, 44A, 44B, ..., 44N; 38, 46A, 46B, ..., 46N) having the second alternating voltage,
 - a power transformer (18) connected between the first panel (14) and the second panel (16) and able to transform the current having the first alternating voltage into the current having the second alternating voltage, and
 - a system (20) for measuring the electrical power ($E_1$, $E_2$, $E_3$, $E_1$-, $E_2$+, $E_2$-, $E_3$+, $E_3$-) of the current flowing in the or each secondary outlet conductor (42A, 44A, 46A, 42B, 44B, 46B, ..., 42N, 44N, 46N),

 **characterised in that** the measurement system (20) is compliant with any one of the preceding claims.

11. Method for measuring the electrical power ($E_1$, $E_2$, $E_3$, $E_1$-, $E_2$+, $E_2$-, $E_3$+, $E_3$-) of the current flowing in at least one secondary electrical conductor (42A, 44A, 46A, 42B, 44B, 46B, ..., 42N, 44N, 46N), the secondary conductor (42A, 42B, .., 42N; 44A, 44B, ..., 44N; 46A, 46B, ..., 46N) being electrically connected to a primary electrical conductor (34; 36; 38), the primary conductor (34; 36; 38) and the or each secondary conductor (42A, 42B, .., 42N; 44A, 44B, ..., 44N; 46A, 46B, ..., 46N) having substantially the same voltage,
the method comprising the following steps:

 - (a) the measurement (210), by a primary module (60), of the voltage (V1, V2, V3) of the current flowing in the primary conductor (34, 36, 38),

- (b) the measurement (330), by a secondary module (62A, ..., 62N), of the intensity (I1, I2A, I3A, ..., I3N) of the current flowing in the corresponding secondary conductor (42A, 44A, 46A, 42B, 44B, 46B, ..., 42N, 44N, 46N), and

- (c) the calculation (340), by the secondary module (62A, ..., 62N), of the electrical power ($E_1$, $E_2$, $E_3$, $E_1$-, $E_2$+, $E_2$-, $E_3$+, $E_3$-) of said current flowing in the corresponding secondary conductor (42A, 44A, 46A, 42B, 44B, 46B, ..., 42N, 44N, 46N),

**characterised in that** the method further comprises the following steps:

- (i) the compression (220) of the measured value of the voltage (V1, V2, V3) and the emission (230), by the primary module (60), of a first message (M1) containing the compressed value of the measured voltage, via a radioelectric link between the primary module (60) and the secondary module (62A, ..., 62N), and

- (ii) the temporal synchronisation (320) of the measurement of the intensity with the measurement of the voltage,

**in that**, during the step (c), the calculation of the electrical power ($E_1$, $E_2$, $E_3$, $E_1$-, $E_2$+, $E_2$-, $E_3$+, $E_3$-) is carried out from the measured value of the voltage received from the primary module (60) and from the measured value of the intensity by the intensity sensor (76A, ..., 76N), and

**in that** the first message (M1) comprises synchronisation data for the temporal synchronisation of the or of each intensity sensor (76A, ..., 76N) in relation to the unit for measuring voltage (66), the date of reception of the first message (M1) being the date of reference for the synchronisation of the at least one first secondary module (62A,...,62N) in relation to primary module (60), and the at least one first secondary module (62A,...,62N) checking that the first message (M1) contains the synchronisation data and to then carry out the temporal synchronisation with the primary module (60).

**12.** - Method according to claim 11, wherein the period ($P_{voltage}$) of the voltage (V1, V2, V3) is measured regularly by the primary module (60), the period of measurement being more preferably equal to 10 seconds.

**FIG.1**

FIG.2

FIG.3

Initialisation et mesure de la fréquence — 200

Mesure de la tension — 210

Compression de la tension mesurée et élaboration du premier message M1 — 220

Emission du premier message M1 — 230

## FIG.4

Réception des premier et deuxième messages M1, M2 — 400

Horodatage et stockage des valeurs reçues — 410

Calcul du facteur de puissance — 420

Affichage des grandeurs mesurées et calculées — 430

Communication des grandeurs mesurées et calculées à un serveur distant — 440

## FIG.6

Initialisation et ouverture d'une fenêtre glissante de réception ⟋300

Réception du premier message M1 ⟋310

Synchronisation temporelle avec le module primaire ⟋320

Mesure de l'intensité ⟋330

Compression de l'intensité mesurée et calcul de l'énergie électrique ⟋340

Elaboration du deuxième message M2 ⟋350

Emission du deuxième message M2 selon un mécanisme de jeton distribué ⟋360

## FIG.5

| Préambule<br>4 octets | SFD<br>1 octet | PHD<br>1 octet | Données<br>n octets | CRC<br>2 octets |
|---|---|---|---|---|

M1

$D_p$

$T_e$

$T_r$

t

Emission radio par émetteur

IT par récepteur

## FIG.7

**EP 2 739 982 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050083206 A1
- WO 2009140777 A1
- WO 2010119332 A1